# EUROPEAN PATENT APPLICATION

(11) **EP 2 241 436 A1**
(43) Date of publication of application: **20.10.2010**
(21) Application number: 08872091.7
(22) Date of filing: 25.12.2008
(51) Int. Cl.: B32B 15/088, B32B 15/08, C23C 28/02, H05K 1/03

(54) **ADHESIVE-FREE FLEXIBLE LAMINATE**

(30) Priority: 04.02.2008 JP 2008024019
(71) Applicant: Nippon Mining & Metals Co., Ltd., Tokyo 105-0001 (JP)
(72) Inventor: MAKINO, Nobuhito, Hitachi-city Ibaraki 317-0056 (JP); HOKURA, Akito, Hitachi-city Ibaraki 317-0056 (JP); INAZUMI, Hajime, Hitachi-city Ibaraki 317-0056 (JP)
(74) Representative: Hoarton, Lloyd Douglas Charles
(86) International application number: PCT/JP2008/073531
(87) International publication number: WO 2009/098832

(57) **Abstract**

Provided is a non-adhesive flexible laminate comprising a polyimide film at least one surface of which has been plasma-treated, a tie-coat layer formed on the plasma-treated surface, a metal seed layer formed on the tie-coat layer, and a metal conductor layer formed on the metal seed layer, wherein a ratio ρₚ/ρₜ of actual density ρₚ to theoretical density ρₜ of the tie-coat layer satisfies ρₚ/ρₜ > 0.6. The invention aims to improve the adhesion between the metal layer and the polyimide film of the non-adhesive flexible laminate (in particular a two-layered metalizing laminate).

## Description

### TECHNICAL FIELD

The present invention relates to a non-adhesive flexible laminate used as a mounting material for electronic components such as flexible print substrates, TAB, and COF.

### BACKGROUND ART

An FCCL (Flexible Copper Clad Laminate), in which metal conductor layers primarily formed from copper are laminated on a polyimide film, is broadly used as a circuit board material in the electronics industry. Among the above, a non-adhesive flexible laminate (particularly a two-layer metalizing laminate) that does not include an adhesive layer between a polyimide film and a metal layer is a material that is attracting attention pursuant to the demands of finer pitches of the circuit wiring width.

As a method of producing a non-adhesive flexible laminate; in particular a non-adhesive flexible laminate capable of accommodating fine pitches, primarily performed is a so-called metalizing method of forming, in advance, a tie-coat layer configured from a material having favorable adhesion with polyimide, and a metal seed layer to work as a conductor of the cathode/current in the subsequent electroplating process, on a polyimide film by a drying method such as sputtering, CVD, or vapor deposition; and thereafter electroplating is performed to form a metal layer film that becomes a conductor layer of the circuit board (refer to Patent Document 1).

In this metalizing method, in order to increase the adhesion between the metal layer and the polyimide film, modification is carried out by performing plasma treatment to the polyimide film surface in order to eliminate the contaminants on the surface and to improve the surface roughness prior to forming the metal layer (refer to Patent Document 2 and Patent Document 3).

Generally speaking, in this metalizing method, when pre-forming a metal layer on a polyimide film by a dry plating method such as sputtering, the improvement of adhesion and etching properties is being sought through the selection of the interlayer material (refer to Patent Document 4). However, further improvement is required from the perspective of heat treatment during circuit formation and long-term reliability in the usage environment. Nevertheless, the current situation is not sufficient improvement has not yet been made.
[Patent Document 1] Japanese Patent No. 3258296
[Patent Document 2] Japanese Patent No. 3173511
[Patent Document 3] Published Japanese Translations of PCT International Publication No. 2003-519901
[Patent Document 4] Japanese Laid-Open Publication No. H6-120630

### DISCLOSURE OF THE INVENTION

Thus, an object of the present invention is to improve the adhesion between the metal layer and the polyimide film of a non-adhesive flexible laminate (particularly a two-layered metalizing laminate).

In light of the foregoing problems, the present invention provides the following.
A non-adhesive flexible laminate comprising a polyimide film at least one surface of which has been plasma-treated, a tie-coat layer formed on the plasma-treated surface, and a metal conductor layer formed on the tie-coat layer, wherein a ratio ρₚ/ρₜ of actual density ρₚ to theoretical density ρₜ of the tie-coat layer satisfies 0.6, and more desirably satisfies ρₚ/ρₜ > 0.7.

Any one of nickel, chromium, cobalt, a nickel alloy, a chromium alloy, and a cobalt alloy can be used as the tie-coat layer. Any of the above-mentioned materials can increase adhesion between the polyimide film layer and the metal conductor layer, and can be etched when designing a circuit. These materials are useful when manufacturing the non-adhesive flexible laminate.

Nevertheless, since the focus of this invention is to improve adhesion by increasing the density of the tie-coat layer and consequently increasing the contact area of the tie-coat layer and polyimide, it does not depend upon the properties that are specific to a material. Thus, it should be understood that selection of materials other than those listed above cannot be negated.
Copper or a copper alloy can be used as the metal seed layer and the metal conductor layer. Similarly, in this case, selection of materials other than those listed above cannot be negated.

What is most important in the present invention is that the ratio ρₚ/ρₜ of the actual density ρₚ to the theoretical density ρₜ of the tie-coat layer satisfies ρₚ/ρₜ > 0.6, and more preferably satisfies ρₚ/ρₜ > 0.7. It is thereby possible to improve the adhesion of the non-adhesive flexible laminate.

The present invention yields a superior effect of being able to improve the adhesion after lamination of the polyimide film and the metal layer by providing a non-adhesive flexible laminate comprising a polyimide film at least one surface of which has been plasma-treated, a tie-coat layer formed on the plasma-treated surface, and a metal conductor layer formed on the tie-coat layer, wherein a ratio ρₚ/ρₜ of actual density ρₚ to theoretical density ρₜ of the tie-coat layer satisfies ρₚ/ρₜ > 0.6.

### BEST MODE FOR CARRYING OUT THE INVENTION

Specific examples of the present invention are now explained. The ensuing explanation is provided to facilitate the understanding of this invention, and the present invention shall in no way be limited thereby. In other words, various modifications and other embodiments shall be included in the present invention as a matter of course.

The basic process is to form a tie-coat layer on at least one surface of the polyimide film, and additionally form a metal conductor layer on the foregoing surface in order to prepare a non-adhesive flexible laminate. Here, the polyimide film surface is subject to plasma treatment in order to eliminate the contaminants on the surface and modify the surface.

Subsequently, a tie-coat layer is formed on the modified polyimide surface, and a metal seed layer is additionally formed thereon via sputtering. The metal layer to become a conductor layer of the circuit board is thereafter deposited via electroplating. Here, the present inventors discovered that the ratio ρₚ/ρₜ of the actual density ρₚ to the theoretical density ρₜ of the tie-coat layer differs by various changes in the sputtering conditions, and further discovered that ρₚ/ρₜ is important in terms of adhesion as a result of measuring the adhesion strength of these samples.

If the ratio ρₚ/ρₜ of the actual density ρₚ to the theoretical density ρₜ of the tie-coat layer is 1, the tie-coat layer will be formed flawlessly and there will be no void at all. Thus, the polyimide and the tie-coat layer will come in contact across the entire surface thereof, and this will be the theoretical closest contact area.
Meanwhile, if ρₚ/ρₜ < 1, it means that there are voids in the tie-coat layer, and if such voids are formed in an area that comes in contact with the polyimide of the tie-coat layer rather than within the tie-coat layer, the effective contact area between the tie-coat layer and the polyimide will deteriorate.

Since the adhesion strength of the tie-coat layer and the polyimide is the strength of bonding at the contact site x contact area, decrease in the contact area will mean decrease in the adhesion strength. Accordingly, although it is obvious that ρₚ/ρₜ = 1 is the optimal tie-coat layer, it is difficult to realize ρₚ/ρₜ = 1 in light of the actual industrial sputtering technology.
In addition, just because it is not ρₚ/ρₜ = 1, it does not immediately lead to the deterioration of the effective contact area.

The first reason is just because not being ρₚ/ρₜ = 1 does not necessarily mean that all of the voids are formed at the boundary face of the tie-coat layer and the polyimide. The second reason is that since polyimide is configured from macromolecular chains and its single molecule is several ten nm, even if voids are formed at the boundary face of the tie-coat layer and the polyimide, it can be deemed that the effective contact area will not deteriorate if such voids are smaller than a molecular chain in the polyimide.

As a result of intensely studying the relation of ρₚ/ρₜ and adhesion, the present inventors discovered that the adhesion deteriorated at ρₚ/ρₜ < 0.6. In the foregoing case, it was confirmed that voids at levels being influential in the adhesion were formed at the boundary face of the tie-coat layer and the polyimide. The discovery of this relation is a key factor in the devisal of this invention.
The adhesion between the polyimide film and the metal layer of a non-adhesive flexible laminate, in which a tie-coat layer and a metal conductor layer are formed on a plasma-treated surface of a polyimide film, after the lamination is generally measured as "peel strength," and this peel strength increases when ρₚ/ρₜ = 0.6 or more.

If the peel strength is sufficiently strong, peeling will occur inside the polyimide. This is generally referred to as cohesion failure. This occurs because the adhesion of the metal/polyimide boundary face is stronger than the strength of the polyimide itself. Meanwhile, if the contact area of the tie-coat layer and the polyimide decreases, since the non-contact area easily peels at such portion (boundary face), the peeling (interface failure) in the vicinity of the metal/polyimide boundary face and the peeling (cohesion failure) inside the polyimide will coexist, and normal peeling will deteriorate.

The present invention resolves the foregoing problems by providing a non-adhesive flexible laminate comprising a polyimide film at least one surface of which has been plasma-treated, a tie-coat layer formed on the plasma-treated surface, and a metal conductor layer formed on the tie-coat layer, wherein a ratio ρₚ/ρₜ of actual density ρₚ to theoretical density ρₜ of the tie-coat layer satisfies ρₚ/ρₜ > 0.6.

It is well known that the Ar pressure and substrate temperature affect the density of the film formed by sputtering. In addition, the film density is affected by various conditions and interactions in the manufacturing process such as the target shape, mounting method, voltage of plasma discharge, periodicity, strength of magnetic field and its distribution profile during the sputtering process.
The present invention selected favorable conditions among the foregoing conditions in order to achieve ρₚ/ρₜ > 0.6. These are conditions that can be easily carried out by a person skilled in the art who is able to understand the present invention.

### [Examples]

The Examples and Comparative Examples of the present invention are now explained. These Examples are merely illustrative, and the present invention shall in no way be limited thereby. In other words, various modifications and other embodiments based on the technical spirit claimed in the claims shall be included in the present invention as a matter of course.

There is no particular limitation in the material to be used as the polyimide film. For instance, Upilex manufactured by Ube Industries, Ltd., Kapton manufactured by DuPont-Toray Co., Ltd., Apical manufactured by Kaneka Corporation, and other products are commercially available, and the present invention can be applied to any one of these polyimide films. The present invention is not limited to these specific products. In the Examples and Comparative Examples, Upilex-SGA manufactured by Ube Industries, Ltd. is used as the polyimide film.

### (Example 1)

Foremost, the polyimide film was placed in a vacuum apparatus and, after evacuation, the polyimide film was subject to plasma treatment using oxygen.
Subsequently, a tie-coat layer and a metal seed layer were formed by sputtering. The tie-coat layer was formed as Ni-20wt% Cr equivalent to a theoretical density of 25nm, and the metal seed layer was formed as Cu of 300nm.
The sputtering for the tie-coat layer was performed under the following conditions; namely, DC magnetron method with a target-sputtering distance of 80mm, power density of 0.95W/cm², and Ar gas pressure of 0.24Pa.

Subsequently, a two-layered metalizing laminate was prepared by forming a metal conductor layer (thickness of 8µm) made of copper on the foregoing metal seed layer by electroplating.
The adhesion of the samples obtained as described above was measured by JIS C 6471 (a method for testing copper-clad laminates for flexible printed circuit boards). Moreover, after etching the copper layer of the prepared two-layered metalizing laminate as the sample of which the area was accurately measured, the tie-coat layer was etched and melted, and the solution was subject to wet analysis to determine the quantity of the tie-coat layer and calculate the thickness *tₜ* in the case of theoretical density.

Subsequently, in a state where a part of the prepared two-layered metalizing laminate is protected from the etching solution, the remainder was etched until metal was completely eliminated and the polyimide surface was exposed. The protective film was thereafter eliminated, and the remaining copper layer was completely eliminated using an etching solution of nitric acid series.
A sample was prepared in which only the tie-coat layer remains at a certain area on the polyimide film prepared as described, and the actual thickness *tₚ* of the tie-coat layer was measured by measuring the difference between the tie-coat layer portion and the polyimide portion.

Measurement was performed under the following conditions.
Device: Scanning probe microscope SPM-9600 manufactured by SHIMADZU CORPORATION
- Conditions:: Dynamic mode
Scanning range: 100µm ×100µm
Number of pixels: 512 × 512

The ratio *tₚ*/*tₜ* of the actual thickness *t*ₚ of the tie-coat layer obtained as described above to the thickness *tₜ* in the theoretical density sought with wet analysis is equal to the ratio ρₚ/ρₜ of the actual density ρₚ to the theoretical density ρₜ of the tie-coat layer.
Table 1 shows the measured and calculated ρₚ/ρₜ and the peel strength of the sample. Specifically, Table 1 shows the relationship between the ratio ρₚ/ρₜ of the actual density ρₚ to the theoretical density ρₜ of the tie-coat layer, and the peel strength.
Note that the theoretical density was calculated from the density of each of the component elements configuring the tie-coat layer and the ratio of the respective component elements, and Ni density (8.9mg/m³) x 0.8 + Cr density (7.2mg/m³) x 0.2 = 8.56mg/m³ was used.
As shown in Table 1, ρₚ/ρₜ was 0.73 and the peel strength was 0.76kN/m in Example 1. The peel strength improved considerably.

**[Table 1]**

| | ρₚ/ρₜ | Peel Strength kN/m |
|---|---|---|
| Example 1 | 0.73 | 0.76 |
| Example 2 | 0.80 | 0.74 |
| Example 3 | 0.90 | 0.76 |
| Comparative Example | 0.55 | 0.69 |

### [Example 2]

A two-layered metalizing laminate was prepared as a sample with the same method as Example 1 other than changing the power density of sputtering the tie-coat layer to 1.9W/cm². The ρₚ/ρₜ and the peel strength of the obtained sample were measured with the same method as Example 1. The results are also shown in Table 1.
As shown in Table 1, the ρₚ/ρₜ was 0.80 and the peel strength was 0.74kN/m in Example 2. The peel strength improved considerably.

### [Example 3]

A two-layered metalizing laminate was prepared as a sample with the same method as Example 1 other than changing the power density of sputtering the tie-coat layer to 2.9W/cm². The ρₚ/ρₜ and the peel strength of the obtained sample were measured with the same method as Example 1. The results are also shown in Table 1.
As shown in Table 1, the ρₚ/ρₜ was 0.90 and the peel strength was 0.76kN/m in Example 3. The peel strength improved considerably.

### (Comparative Example)

Foremost, the polyimide film was placed in a vacuum apparatus and, after evacuation, the polyimide film was subject to plasma treatment using oxygen. Subsequently, a tie-coat layer and a metal seed layer were formed by sputtering.
The tie-coat layer was formed as Ni-20wt% Cr of 25nm, and the metal seed layer was formed as Cu of 300nm. The sputtering for the tie-coat layer was performed under the following conditions; namely, DC magnetron method with a target-sputtering distance of 50mm, power density of 2.3W/cm², and Ar gas pressure of 0.24Pa.

Subsequently, a two-layered metalizing laminate was prepared by forming a metal conductor layer (thickness of 8µm) made of copper on the foregoing metal seed layer by electroplating.
The ρₚ/ρₜ and the peel strength of the obtained sample were measured with the same method as Example 1. The results are also shown in Table 1.
The ρₚ/ρₜ was 0.55 and the peel strength was 0.69kN/m in Comparative Example 1. The peel strength was inferior in comparison to Examples 1 to 3.

As described above, the peel strength improved at ρₚ/ρₜ > 0.6, and it was possible to achieve a peel strength of 0.70kN/m or more. In addition, as shown in Table 1, in cases of ρₚ/ρₜ > 0.7, the peel strength exceeds 0.70kN/m, and a stable peel strength has been confirmed.
Accordingly, it can be understood that the improvement of the density of the tie-coat layer is a key factor in improving the peel strength. Specifically, by measuring the density of the tie-coat layer (pp), obtaining the ratio to the theoretical density (ρₜ), and adopting the ρₚ/ρₜ as the index; the peel strength can be improved reliably.
It is thereby possible to manufacture a non-adhesive flexible laminate with high peel strength, and obtain such a non-adhesive flexible laminate.

The present invention enables to improve the adhesion after lamination between the polyimide film and the metal layer by providing a non-adhesive flexible laminate comprising a polyimide film at least one surface of which has been plasma-treated, a tie-coat layer formed on the plasma-treated surface, and a metal conductor layer formed on the tie-coat layer, wherein a ratio ρₚ/ρₜ of actual density ρₚ to theoretical density ρₜ of the tie-coat layer satisfies ρₚ/ρₜ > 0.6, and even ρₚ/ρₜ > 0.7. And, the effectiveness of the present invention can be confirmed from the foregoing explanation.

### INDUSTRIAL APPLICABILITY

Since the present invention yields a superior effect of being able to improve the adhesion by providing a non-adhesive flexible laminate comprising a polyimide film at least one surface of which has been plasma-treated, a tie-coat layer formed on the plasma-treated surface, and a metal conductor layer formed on the tie-coat layer, wherein a ratio ρₚ/ρₜ of actual density ρₚ to theoretical density ρₜ of the tie-coat layer satisfies ρₚ/ρₜ > 0.6; it is effective as a non-adhesive flexible laminate to be used as a mounting material for electronic components such as a flexible print substrate, TAB and COF.

## Claims

1. A non-adhesive flexible laminate comprising a polyimide film at least one surface of which has been plasma-treated, a tie-coat layer formed on the plasma-treated surface, a metal seed layer formed on the tie-coat layer, and a metal conductor layer formed on the metal seed layer, wherein a ratio ρₚ/ρₜ of actual density ρₚ to theoretical density ρₜ of the tie-coat layer satisfies ρₚ/ρₜ > 0.6.

2. The non-adhesive flexible laminate according to claim 1, wherein the ratio ρₚ/ρₜ of the actual density ρₚ to the theoretical density ρₜ of the tie-coat layer satisfies ρₚ/ρₜ > 0.7.

3. The non-adhesive flexible laminate according to claim 1 or claim 2, wherein the tie-coat layer is configured from any one among nickel, chromium, cobalt, nickel alloy, chromium alloy, and cobalt alloy.

4. The non-adhesive flexible laminate according to any one of claims 1 to 3, wherein the metal seed layer and the metal conductor layer are configured from any one of copper or copper alloy.
